# EUROPÄISCHE PATENTSCHRIFT

(11) **EP 0 867 036 B1**
(45) Veröffentlichungstag und Bekanntmachung des Hinweises auf die Patenterteilung: **18.07.2001**
(21) Anmeldenummer: 96939061.6
(22) Anmeldetag: 15.11.1996
(51) Int. Cl.: H01J 37/32, C23C 14/02, C23C 14/35

(54) **VERFAHREN UND EINRICHTUNG ZUR VORBEHANDLUNG VON SUBSTRATEN**
METHOD AND DEVICE FOR PRE-TREATMENT OF SUBSTRATES
PROCEDE ET DISPOSITIF POUR LE PRETRAITEMENT DE SUBSTRATS

(30) Priorität: 15.12.1995 DE 19546826
(43) Veröffentlichungstag der Anmeldung: 30.09.1998
(73) Patentinhaber: FRAUNHOFER-GESELLSCHAFT ZUR FÖRDERUNG DER ANGEWANDTEN FORSCHUNG E.V., 80636 München (DE)
(72) Erfinder: GOEDICKE, Klaus, D-01307 Dresden (DE); FIETZKE, Fred, D-01127 Dresden (DE); RESCHKE, Jonathan, D-01307 Dresden (DE); HEMPEL, Wolfgang, D-01217 Dresden (DE); SCHEFFEL, Bert, D-01324 Dresden (DE); METZNER, Christoph, D-01474 Pappritz (DE); SCHILLER, Siegfried, D-01324 Dresden (DE)
(86) Internationale Anmeldenummer: EP9605032
(87) Internationale Veröffentlichungsnummer: WO9722988

(56) Entgegenhaltungen:
- EP-A- 0 553 410
- WO-A-95/03682
- DE-A- 4 239 218
- DE-C- 19 500 262
- DE-U- 9 109 503

## Beschreibung

Die Erfindung betrifft ein Verfahren und die dazugehörige Einrichtung zur Vorbehandlung elektrisch leitfähiger oder elektrisch isolierender Substrate im Vakuum. Bevorzugtes Anwendungsgebiet ist die Behandlung von Oberflächen, welche in einem anschließenden Vakuumbeschichtungsprozeß mit einem haftfesten Überzug versehen werden sollen. Nach dem Verfahren werden beispielsweise Werkzeuge aus Stahl, Hartmetall oder Keramik behandelt.

Es ist bekannt (R.A. Haefer: Oberflächen- und Dünnschicht-Technologie, Teil I, S. 30 ff, Springer-Verlag, Berlin 1987), daß im Vakuum zu beschichtende Substrate einem mehrstufigen Vorbehandlungsprozeß unterworfen werden müssen. Dieser besteht meist aus einem oder mehreren mechanischen oder chemischen Reinigungsschritten sowie einer anschließenden Vakuumbehandlung in der Beschichtungsanlage. Hier werden störende Oberflächenschichten, z.B. Wasserhäute oder dünne Oxidschichten, beseitigt, gegebenenfalls Keimstellen für die abzuscheidende Schicht geschaffen oder sogar haftverbessernde Zwischenschichten aufgebracht.

In Abhängigkeit von der elektrischen Leitfähigkeit der Substrate sind verschiedene Verfahren zur Vakuum-Vorbehandlung entwickelt worden.
Elektrisch isolierende Substrate wie Glas oder Oxidkeramiken werden häufig durch eine Glimmentladung gereinigt, welche zwischen dem geerdeten Substrathalter als Anode und einer speziellen Glimmelektrode als Katode in einem Arbeitsgas, vorzugsweise Argon, im Druckbereich von 10 Pa gezündet wird. Dabei wird das Substrat von Elektronen getroffen, die vor allem die Desorption von Fremdschichten, insbesondere der Wasserhaut, bewirken und das Substrat aufheizen. Weiterhin können durch Zerstäubung von Elektrodenmaterial Kondensationskeime entstehen. Der wesentliche Nachteil dieses Verfahrens besteht in den geringen erzielbaren Stromdichten und damit seiner geringen Effizienz. Weiterhin ist es nicht möglich, thermisch stabile Fremdschichten, z.B. aus Oxiden, durch Elektronenbeschuß des Substrates zu entfernen.
Elektrisch leitfähige Substrate wie Metalle werden am einfachsten durch einen Zerstäubungsprozeß vorbehandelt. Die hierzu notwendige Entladung wird zwischen dem negativ vorgespannten Substrat als Katode sowie der geerdeten Vakuumkammer oder einer Ätzelektrode als Anode gezündet. Durch lonenbeschuß am Substrat werden vor allem Fremdatome durch Zerstäuben abgetragen und die Oberfläche des Substrates aktiviert. Weitere Teilchen und Strahlungsquanten des Plasmas unterstützen die Aktivierung durch Wechselwirkung mit der Substratoberfläche.
Es ist bekannt, die Wirkung der Vorbehandlung in Abhängigkeit vom Substratmaterial durch den Einsatz eines reduzierend oder oxidierend wirkenden Gasgemisches zu steigern
(DE 31 44 192).
Es ist weiterhin bekannt, daß die Überlagerung eines Magnetfeldes, insbesondere nach dem Magnetronprinzip, zu einer Verstärkung der Entladung und damit zu einer Intensivierung der Vorbehandlung führt (DD 136 047).
Die Substrat-Vorbehandlung durch eine Gleichstrom-Glimmentladung weist häufig Prozeß-Instabilitäten auf. Sie haben ihre Ursache in der elektrischen Aufladung isolierender Bereiche der Substratoberfläche, z.B. oxidischer Inseln, und dem dadurch bedingten Umschlagen der Glimmentladung in eine Bogenentladung. Diese als "arcing" bezeichnete Erscheinung verhindert nicht nur die Abtragung von Fremdschichten, sondern führt zu einer lokalen Schädigung der Substrat-Oberfläche.
Ein bekanntes Verfahren, welches diese Nachteile überwindet, ist das Vorbehandeln in einem RF-Plasma, vorzugsweise bei einer Frequenz von 13,56 MHz. Für isolierende Substrate muß generell ein RF-Plasma angewandt werden. Bei geeigneter Gestaltung der Elektrodenflächen bildet sich eine sogenannte Selbstbias-Spannung aus, die einen Strom beschleunigter lonen zum Substrat erzeugt. Dadurch werden zahlreiche Elementarprozesse ausgelöst, die zu einer Reinigung der Substrat-Oberfläche durch Zerstäuben und zu einer Aktivierung der Oberfläche führen. Alle RF-Verfahren haben den Nachteil eines geringen Wirkungsgrades, hoher Energieverluste bei der elektrischen Anpassung und eines hohen technischen Aufwandes. Insbesondere für großflächige Substrate ist eine homogene Substrat-Vorbehandlung praktisch nicht möglich.

Es ist ebenfalls bekannt, eine Vorbehandlung von Substraten im Vakuum durch den Einsatz von Ladungsträgerquellen zu erreichen. Mittels Elektronenstrahlquellen wird im wesentlichen eine Aufheizung des Substrates und eine Desorption flüchtiger Adsorbatschichten erreicht. Durch den Beschuß von Substraten mit lonenquellen oder Plasmaquellen können auch nichtflüchtige Oberflächenschichten durch Zerstäuben abgetragen werden (DD 292 028; DE 37 08 717 C2).
Erfolgt der Beschuß der Substrate mit Metallionen (Kadlec et al., Surf. Coat. Technol., 54/55, 1992, 287-296), so wird weiterhin die Bildung einer Mischschicht aus Substratatomen und implantierten Fremdatomen erreicht. Deshalb ist dieser Prozeß auch als "ion mixing" bekannt. Er führt zu sehr guter Haftfestigkeit der anschließend im Vakuum aufgebrachten
Schichten. Allen genannten Strahlverfahren zur Vorbehandlung von Substraten haftet jedoch der Nachteil eines sehr hohen apparativen Aufwandes und damit hoher Kosten an. Das gilt insbesondere für großflächige Substrate.
Für spezielle Anwendungen, z.B. die Vorbehandlung von Polymeroberflächen, ist auch der Einsatz von Mikrowellen-Plasmen bekannt. Mit ihnen wird kein Abtrag von Fremdschichten, sondern eine Veränderung der physikalischen und chemischen Bindungszustände zwischen Substrat- und Schichtmaterial erreicht. Die Wirksamkeit ist extrem materialabhängig und an die chemische Natur von Substrat- und Schichtmaterial geknüpft.

Der Erfindung liegt die Aufgabe zugrunde, ein Verfahren und eine zugehörige Einrichtung zur Vorbehandlung mit daran anschließender Vakuumbeschichtung elektrisch leitender und nichtleitender Substrate anzugeben, die den technischen Aufwand für die Substrat-Vorbehandlung gegenüber einer Behandlung im RF-Plasma oder mittels Strahlquellen entscheidend verringert. Weiterhin soll die Wirksamkeit der Vorbehandlung erhöht und den Eigenschaften des Substratmaterials sowie der anschließend aufzubringenden Schicht angepaßt werden. Das Verfahren soll problemlos mit dem eigentlichen Vakuumbeschichtungsprozeß kombinierbar sein.

Erfindungsgemäß wird die Aufgabe nach einem Verfahren mit den Merkmalen des Anspruches 1 gelöst. Die erfindungsgemäße Einrichtung ist durch die Merkmale des Anspruches 8 beschrieben. Vorteilhafte Ausgestaltungen beschreiben die Ansprüche 2 bis 7 bzw. 9 bis 12.

Das erfindungsgemäße Verfahren bewirkt, daß das Substrat periodisch wechselnd mit einem Strom beschleunigter Elektronen und lonen beaufschlagt wird. Das Substrat ist weiterhin permanent der Wechselwirkung mit weiteren Teilchen und Strahlungsquanten eines Plasmas ausgesetzt, insbesondere mit energiereichen Neutralteilchen und Strahlung aus dem Plasma. Die chemische und physikalische Wirkung eines Teils der auftreffenden lonen wird von der Auswahl des Elektrodenmaterials bestimmt. Die Gegenelektrode besteht aus dem Material der anschließend aufzubringenden Schicht oder mindestens einer Komponente dieses Schichtmaterials. Es ist je nach dem durchzuführenden Beschichtungsprozeß auch möglich, die Gegenelektrode aus einem anderen geeigneten Material herzustellen. Es kann weiterhin ein reduzierend wirkendes Gas, z.B. Wasserstoff, während des Vorbehandlungsprozesses in die Vakuumkammer eingelassen werden, welches im Plasma aktiviert bzw. ionisiert wird und durch chemische Reaktionen den Prozeß der Substratvorbehandlung unterstützt. Insgesamt wird durch das Verfahren eine sehr komplexe physikalische und chemische Reaktion auf der Substratoberfläche und im oberflächennahen Bereich des Substrates bewirkt.

Charakteristisch für das Verfahren ist die Eignung für elektrisch leitende und nichtleitende Substrate. Die Frequenz des Polwechsels der Energieeinspeisung sichert, daß eine elektrische Aufladung isolierender Bereiche der Substratoberfläche verhindert wird. Dadurch wird das im Gleichstromplasma auftretende "arcing" vermieden. Weiterhin ist die Frequenz des Polwechsels so bemessen, daß die lonen des Plasmas während jedes Pulses einen ausreichend hohen Energiebetrag aus dem elektrischen Feld der Entladung übertragen bekommen.
Besonders vorteilhaft ist, daß Art und Intensität der bevorzugt auf dem Substrat ablaufenden Elementarprozesse in einfacher Weise durch Einstellung elektrischer Parameter der Energieversorgungseinrichtung ausgewählt werden können. Das gewählte Verhältnis der Pulslängen beider Polungen bestimmt das Verhältnis von Elektronen- und lonenstrom zum Substrat. Durch Wahl der Entladungsspannung in beiden Polungen wird die Energieverteilung der Elektronen und lonen festgelegt. Damit wird aktiv darauf Einfluß genommen, in welchem Maße solche Elementarprozesse wie Desorption locker gebundener Adsorbate, Zerstäuben von Fremdschichten, Zerstäuben von Substratmaterial, Erwärmung des Substrates und damit Erhöhung der lateralen Beweglichkeit, Diffusionsvorgänge und Implantation von Elektrodenmaterial in den oberflächennahen Substratbereich ablaufen. Dadurch ist der Vorbehandlungsprozeß nicht nur eine physikalische und/oder chemische Reinigung des Substrates, sondern es werden in gezielter Weise die Haftfestigkeit und die Struktur der aufzubringenden Schicht vorbestimmt.
Es kann auch vorteilhaft sein, besagte Glimmentladung in einem oxidisch wirkenden Gasgemisch zu betreiben. Das gilt vor allem, wenn Substrat- und Schichtmaterial aufgrund ihrer chemischen Natur eine oxidische Bindung eingehen.
Das Verfahren läßt sich besonders vorteilhaft betreiben, wenn die Gegenelektrode im Feld einer speziellen Magnetanordnung - einer an sich bekannten Magnetronanordnung - ang eordnet ist. Dadurch kann die Plasmadichte und die Effizienz der Vorbehandlung größenordnungsmäßig gesteigert werden.
In den Fällen, in denen die anschließende Aufbringung einer Schicht durch Magnetron-Zerstäuben erfolgen soll, ist es besonders vorteilhaft, mindestens eine der für die Schichtabscheidung vorgesehenen Zerstäubungsquellen als Gegenelektrode für die Vorbehandlung der Substrate zu nutzen.
Die Einrichtung zur Durchführung des erfindungsgemäßen Verfahrens besteht im wesentlichen aus dem Rezipienten, in dem die zu behandelnden Substrate gehaltert sind, der Gegenelektrode, Evakuierungseinrichtung und Stromversorgung. Als Stromversorgung dient ein Wechselspannungserzeuger, dessen Anschlüsse mit dem Substrat und mindestens einer Gegenelektrode verbunden sind. Mit dem Wechselspannungserzeuger ist eine Regeleinrichtung verbunden, die zur Änderung der Frequenz, der Pulslänge und/oder Entladungsspannung dient. Weiterhin umfaßt die Einrichtung Mittel zum Einlaß eines Arbeitsgases in die Prozeßkammer sowie zur Druckregelung, wie sie allgemein für Plasmaprozesse bekannt sind.

Der Wechselspannungserzeuger kann ein Bipolar-Puls-Generator sein, dessen Pulslängen und/oder Ausgangsspannungen für beide Polungen getrennt einstellbar sind. In vereinfachter Weise kann der Wechselspannungserzeuger auch durch Zusammenschaltung eines Sinusgenerators und einer einstellbaren Gleichspannungsquelle gebildet werden. Durch Übe rlagerung beider Spannungen kann des Verhältnis von Elektronen- und lonenstrom zum Substrat dem Prozeß angepaßt werden.
Für eine leistungsfähige Einrichtung zur Durchführung des Verfahrens ist es zweckmäßig, eine wassergekühlte Gegenelektrode vorzusehen.

An zwei Ausführungsbeispielen wird der Gegenstand der Erfindung näher erläutert.
In den zugehörigen Zeichnungen zeigen:
- Fig. 1:: eine Einrichtung zur Vorbehandlung eines elektrisch isolierenden Substrates mit einem Bipolar-Puls-Generator,
- Fig. 2:: eine Anordnung zur Vorbehandlung eines elektrisch leitenden, partiell oxydierten Substrates mit einem Sinusgenerator.

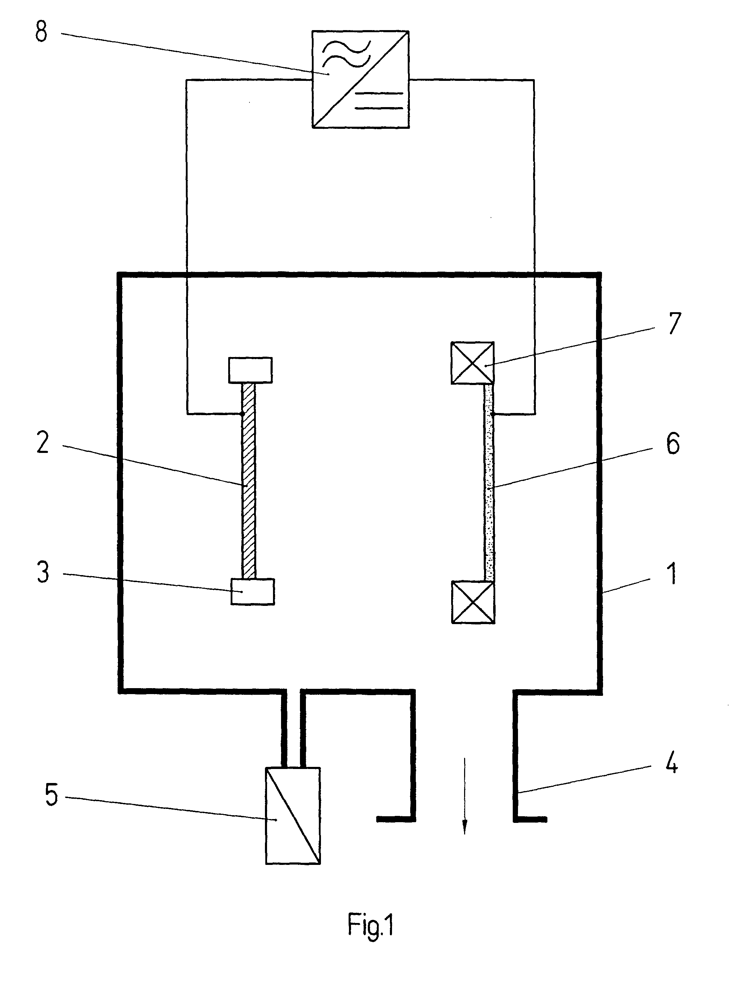

In Fig. 1 ist in einer Prozeßkammer 1 ein isolierendes Substrat 2 aus einer Oxidkeramik in einer Halterung 3 angeordnet. Am Anschluß 4 ist an die Prozeßkammer ein bekanntes Vakuumpumpsystem angeschlossen. Mittels eines Regelventils 5 wird ein Argon-Sauerstoff-Gasgemisch mit einem Sauerstoff-Gehalt von 10 vol% in die Prozeßkammer 1 eingelassen und auf einen Druck von 0,5 Pa geregelt. In einem Abstand von 100 mm ist parallel zum Substrat 2 eine Gegenelektrode 6 angeordnet. Sie befindet sich im Magnetfeld einer M agnetspule 7. Die Gegenelektrode 6 besteht aus Edelstahl, die anschließend auf das Substrat 2 abzuscheidende Schicht soll ebenfalls aus Edelstahl bestehen.
Zur Vorbehandlung der Substratoberflächen sind Halterung 3 und somit auch das Substrat 2 und Gegenelektrode 6 potentialfrei und mit den Anschlüssen eines Wechselspannungserzeugers 8, der ein Bipolar-Puls-Generator ist, verbunden. Seine Maximalleistung beträgt 10 kW bei einer maximalen Ausgangsspannung von jeweils 1500 V für jede Polung. Der Wechselspannungserzeuger 8 wird mit einer festen Frequenz des Polwechsels von 50 kHz betrieben. Die Pulslängen für katodische und anodische Polung des Substrates 2 werden im Verhältnis 20:1 eingestellt. Die Ausgangsspannung wird für beide Polungen auf 1200 V eing estellt. Bei einer Vorbehandlungszeit von 2 Minuten wird ein mittlerer Abtrag von 20 nm am Substrat 2 und eine Temperaturerhöhung um 410 °C erreicht. In einem anschließenden Beschichtungsprozeß wird durch Elektronenstrahlverdampfung auf dem Substrat 2 eine 20 µm dicke Edelstahlschicht extrem hoher Haftfestigkeit und Dichte abgeschieden. Ein Querschliff der beschichteten Substrate 2 zeigt, daß sich im Ergebnis der Substratvorbehandlung eine "Intermixing-Zone" von etwa 200 nm gebildet hat, die neben dem Substratmaterial auch metallische Bestandteile enthält. Sie ist offensichtlich durch Implantation und Diffusion entstanden.

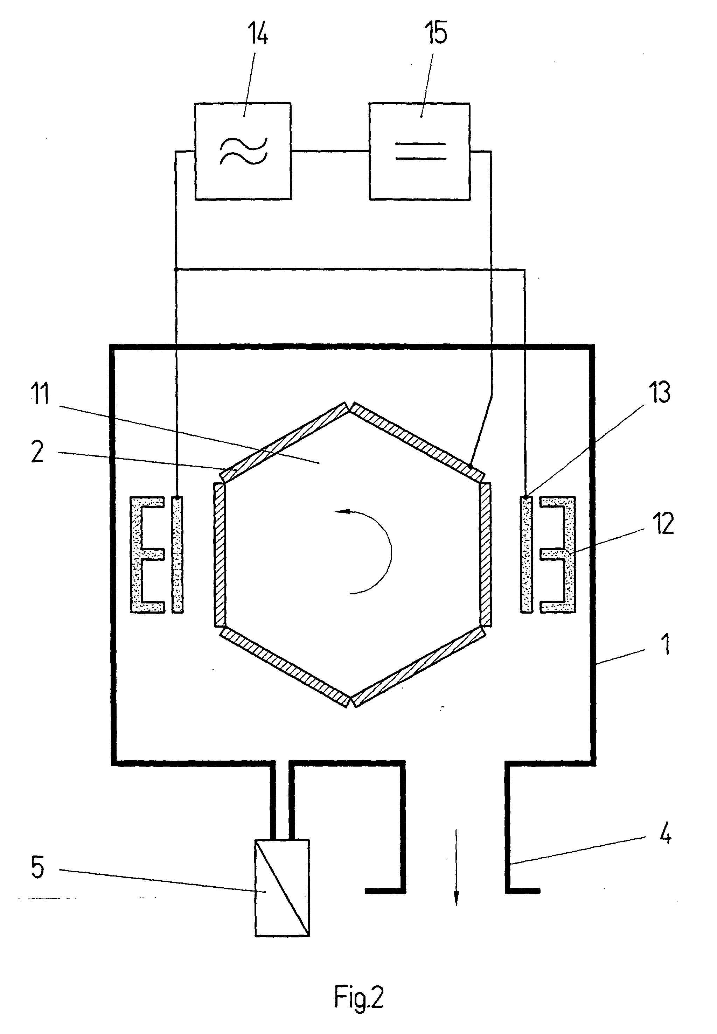

In Fig. 2 sollen durch reaktives Magnetronzerstäuben metallisch leitende Substrate 2 mit einer 10 µm dicken Titanoxid-Schicht versehen werden. In einer Prozeßkammer 1 sind die Substrate 2 aus Hartmetall auf einem rotierenden Substratträger 11 befestigt. Am Anschluß 4 ist an die Prozeßkammer 1 ein bekanntes Vakuumpumpsystem angeschlossen. Ein Regelventil 5 dient zum Einlaß eines Gasgemisches, welches aus Argon mit einem Gehalt von 5 vol% Wasserstoff besteht. Der Totaldruck wird auf einem Wert von 1 Pa konstantgehalten. In einem mittleren Abstand von 80 mm zum Substratträger 11 sind zwei gegenüberliegende Magnetron-Zerstäubungsquellen 12 mit Titan-Targets 13 angeordnet. Sie dienen auch zum anschließenden Aufbringen der Titanoxid-Schicht durch Magnetron-Zerstäuben. Zur Durchführung der Substrat-Vorbehandlung als Wechselspannungserzeuger wird eine Kombination aus einem Sinusgenerator 14 und einer einstellbaren Gleichspannungsquelle 15 potentialfrei zwischen die Substrate 2 und die durch Parallelschaltung verbundenen Magnetron-Zerstäubungsquellen 12 geschaltet. Somit wirken die Targets der Magnetron-Zerstäubungsquellen 12 als Gegenelektrode für den Vorbehandlungsprozeß.
Der Sinusgenerator 14 wird mit einer Frequenz von 50 kHz und einer Ausgangsspannung von 1500 V betrieben. Die Gleichspannungsquelle 15 wird auf einen Wert von 650 V eing estellt. Durch Überlagerung der beiden Spannungen wird erreicht, daß bei katodischer Polung der Substrate 2 sowohl Pulslänge als auch Entladungsspannung wesentlich größer sind als bei anodischer Polung. Bei einer Vorbehandlungszeit von 10 Minuten wird ein mittlerer Abtrag von weniger als 10 nm am Substrat 2 und eine Temperaturerhöhung um 300 °C e rreicht. Die nach dieser Vorbehandlung aufgebrachten Zerstäubungsschichten zeichnen sich durch eine sehr hohe Haftfestigkeit aus. Der Scratch-Test ergab bei einer Grenzlast des Gerätes von 30 N keinerlei Schichtablösungen.

## Patentansprüche

1. Verfahren zur Vorbehandlung von Substraten im Vakuum durch Glimmentladung mit daran anschließender Vakuumbeschichtung, **dadurch gekennzeichnet,** daß zwischen dem zu reinigenden Substrat und einer Gegenelektrode, die aus dem Material oder mindestens einer Komponente der in dem Vakuumbeschichtungsprozeß aufzubringenden Schicht besteht, eine Niederdruck-Glimmentladung derart aufrechterhalten wird, daß das Substrat periodisch abwechselnd als Katode oder Anode der Niederdruck-Glimmentladung wirkt, daß die Frequenz des Polwechsels im Bereich 1 Hz bis 1000 kHz, vorzugsweise 20 bis 50 kHz, eingestellt wird und daß die Pulslängen und/oder die Entladungsspannung in beiden Polungen einzeln eingestellt werden.

2. Verfahren nach Anspruch 1, **dadurch gekennzeichnet,** daß die Niederdruck-Glimmentladung magnetisch, vorzugsweise nach dem Magnetronprinzip, verstärkt wird.

3. Verfahren nach Anspruch 1 und 2, **dadurch gekennzeichnet,** daß die Niederdruck-Glimmentladung in einem Inertgas, vorzugsweise Argon, aufrechterhalten wird.

4. Verfahren nach Anspruch 1 und 2, **dadurch gekennzeichnet,** daß die Niederdruck-Glimmentladung in einem reduzierend wirkenden Gasgemisch, welches vorzugsweise Wasserstoff enthält, aufrechterhalten wird.

5. Verfahren nach Anspruch 1 und 2, **dadurch gekennzeichnet,** daß die Niederdruck-Glimmentladung in einem oxidierend wirkenden Gasgemisch, welches vorzugsweise Sauerstoff enthält, aufrechterhalten wird.

6. Verfahren nach Anspruch 1 bis 5, **dadurch gekennzeichnet,** daß die Pulslänge bei anodischer Polung des Substrates größer als bei katodischer Polung eingestellt wird.

7. Verfahren nach Anspruch 1 bis 5, **dadurch gekennzeichnet,** daß die Pulslänge bei katodischer Polung des Substrates größer als oder gleich groß wie bei anodischer Polung eingestellt wird.

8. Einrichtung zur Durchführung des Verfahrens nach Anspruch 1, bestehend aus einem evakuierbaren Rezipienten, in dem die zu behandelnden Substrate gehaltert und mindestens eine Gegenelektrode angeordnet sind, und einem Wechselspannungserzeuger, der mit einer Regeleinrichtung zur Änderung der Frequenz, der Pulslänge und/oder Entladungsspannung verbunden ist, **dadurch gekennzeichnet,** daß die Substrate (2) und die Gegenelektrode (6) potentialfrei angebracht und mit dem Wechselspannungserzeuger (8) verbunden sind.

9. Einrichtung nach Anspruch 8, **dadurch gekennzeichnet,** daß der Wechselspannungserzeuger ein Bipolar-Puls-Generator mit getrennt einstellbaren Pulslängen und/oder Ausgangsspannungen für be ide Polungen ist.

10. Einrichtung nach Anspruch 8, **dadurch gekennzeichnet,** daß der Wechselspannungserzeuger (8) aus einem Sinusgenerator (14) und einer einstellbaren Gleichspannungsquelle (15) zusammengeschaltet ist.

11. Einrichtung nach Anspruch 8 bis 10, **dadurch gekennzeichnet,** daß mindestens eine der zur nach dem Vorbehandlungsprozeß erfolgenden Vakuumbeschichtung eingesetzten Magnetron-Zerstäubungsquellen (12) als Gegenelektrode geschaltet und wirksam ist.

12. Einrichtung nach Anspruch 9, **dadurch gekennzeichnet,** daß die Gegenelektrode wassergekühlt ist.

## Claims

1. Method for pretreatment of substrates in a vacuum by glow discharge with subsequent vacuum-coating, **characterised in that,** between the substrate to be cleaned and a backing electrode, which is made of the material or at least of one component of the layer to be deposited in the vacuum-coating process, a low-pressure glow discharge is maintained in such a manner that the substrate operates in a periodically alternating manner as cathode or anode of the low-pressure glow discharge, that the frequency of the polarity change is set in the range of 1Hz to 1000 kHz, preferably 20 to 50 kHz and that the pulse lengths and/or the discharge voltage in both polarities are set individually.

2. Method according to claim 1, **characterised in that** the low-pressure glow discharge is amplified magnetically, preferably according to the magnetron principle.

3. Method according to claim 1 and 2, **characterised in that** the low-pressure glow discharge is maintained in an inert gas, preferably argon.

4. Method according to claim 1 and 2, **characterised in that** the low-pressure glow discharge is maintained in a reduction-effecting gas mixture which preferably contains hydrogen.

5. Method according to claim 1 and 2, **characterised in that** the low-pressure glow discharge is maintained in an oxidation-effecting gas mixture which preferably contains oxygen.

6. Method according to claim 1 to 5, **characterised in that** the pulse length is set greater in the case of anodic polarity of the substrate than in the case of cathodic polarity.

7. Method according to claim 1 to 5, **characterised in that** the pulse length in the case of cathodic polarity of the substrate is set greater than or as great as that in the case of anodic polarity.

8. Device for implementing the method according to claim 1, comprising an evacuatable receptacle, in which the substrates to be treated are mounted, and at least one backing electrode and an alternating voltage generator, which is connected to an adjustment device for changing the frequency, the pulse length and/or the discharge voltage, **characterised in that** the substrates (2) and the backing electrode (6) are applied potential-free and are connected to the alternating voltage generator (8).

9. Device according to claim 8, **characterised in that** the alternating voltage generator is a bipolar-pulse generator with separately adjustable pulse lengths and/or output voltages for both polarities.

10. Device according to claim 8, **characterised in that** the alternating voltage generator (8) is interconnected from a sine generator (14) and an adjustable direct voltage source (15).

11. Device according to claim 8 to 10, **characterised in that** at least one of the magnetron sputter sources (12) used for vacuum-coating, which is effected after the pretreatment process, is connected and operates as a backing electrode.

12. Device according to claim 9, **characterised in that** the backing electrode is water-cooled.

## Revendications

1. Procédé pour le prétraitement de substrats sous vide, par décharge luminescente, avec revêtement sous vide subséquent,
caractérisé en ce que
entre le substrat à nettoyer et une contre-électrode qui est constituée du matériau ou d'au moins un composant de la couche à appliquer dans le processus de revêtement sous vide, on maintient une décharge luminescente à basse pression, de sorte que le substrat périodiquement joue en alternance le rôle de cathode ou d'anode de la décharge luminescente à basse pression, la fréquence de l'inversion de polarité est ajustée dans la plage de 1 Hz à 1 000 kHz, de préférence de 20 à 50 kHz, et les longueurs d'impulsions et/ou la tension de décharge dans les deux polarisations sont réglées individuellement.

2. Procédé selon la revendication 1,
caractérisé en ce que
la décharge luminescente à basse pression est renforcée par magnétisme, de préférence selon le principe du magnétron.

3. Procédé selon la revendication 1 ou 2,
caractérisé en ce que
la décharge luminescente à basse pression est maintenue dans un gaz inerte, l'argon de préférence.

4. Procédé selon la revendication 1 ou 2,
caractérisé en ce que
la décharge luminescente à basse pression est maintenue dans un mélange gazeux à effet réducteur, qui contient de préférence de l'hydrogène.

5. Procédé selon la revendication 1 ou 2,
caractérisé en ce que
la décharge luminescente à basse pression est maintenue dans un mélange gazeux à effet oxydant, qui contient de préférence de l'oxygène.

6. Procédé selon l'une quelconque des revendications 1 à 5,
caractérisé en ce que
la longueur d'impulsions dans le cas de la polarisation anodique du substrat est réglée à une valeur plus élevée que dans le cas de la polarisation cathodique.

7. Procédé selon l'une quelconque des revendications 1 à 5,
caractérisé en ce que
la longueur d'impulsions dans le cas de la polarisation cathodique du substrat est réglée à une valeur plus élevée ou à la même valeur que dans le cas de la polarisation anodique.

8. Dispositif pour la mise en oeuvre du procédé selon la revendication 1, constitué d'un récipient pouvant être mis sous vide, dans lequel sont disposés les substrats à traiter sur support et au moins une contre-électrode, et d'un générateur de tension alternative qui est raccordé à un dispositif de réglage pour la variation de la fréquence, de la longueur d'impulsions et/ou de la tension de décharge,
caractérisé en ce que
les substrats (2) et la contre-électrode (6) sont disposés sans tension et sont reliés au générateur de tension alternative (8).

9. Dispositif selon la revendication 8,
caractérisé en ce que
le générateur de tension alternative est un générateur d'impulsion bipolaire à longueurs d'impulsions et/ou tensions de sortie réglables séparément pour les deux polarités.

10. Dispositif selon la revendication 8,
caractérisé en ce que
le générateur de tension alternative (8) est constitué par la combinaison d'un générateur sinusoïdal (14) et d'une source de tension continue (15) réglable.

11. Dispositif selon l'une quelconque des revendications 8 à 10,
caractérisé en ce que
au moins l'une des sources (12) de pulvérisation cathodique par magnétron utilisées pour le revêtement sous vide effectué après le processus de prétraitement, est mise en circuit et activée en tant que contre-électrode.

12. Dispositif selon la revendication 9,
caractérisé en ce que
la contre-électrode est refroidie avec de l'eau.
